# EUROPEAN PATENT SPECIFICATION

(11) **EP 2 980 267 B1**
(45) Date of publication and mention of the grant of the patent: **01.05.2019**
(21) Application number: 15178336.2
(22) Date of filing: 24.07.2015
(51) Int. Cl.: C23C 14/32, C23C 14/08, C23C 14/00

(54) **CORUNDUM-TYPE FE-DOPED CATHODIC ARC EVAPORATED AL-CR-O COATINGS**
KORUNDARTIGE FE-DOTIERTE KATHODISCHE LICHTBOGEN-AUFGEDAMPFTE AL-CR-O-BESCHICHTUNGEN
REVÊTEMENTS AL-CR-O DE TYPE CORUNDUM DOPÉS AU FE ÉVAPORÉS PAR ARC CATHODIQUE

(30) Priority: 28.07.2014 US 201462029742 P
(43) Date of publication of application: 03.02.2016
(73) Proprietor: Oerlikon Surface Solutions AG, Trübbach, 9477 Trübbach (CH)
(72) Inventor: KOLLER, Christian Martin, 8793 Trofaiach (AT); RAMM, Juergen, 7304 Maienfeld (CH); MAYRHOFER, Paul Heinz, 7311 Neckenmarkt (AT); POLCIK, Peter, 6600 Reutte (AT); PAULITSCH, Joerg, 2514 Möllersdorf (AT)
(74) Representative: Troesch Scheidegger Werner AG

(56) References cited:
- US-A1- 2009 269 600
- US-A1- 2013 048 490
- RAMM J ET AL: "Correlation between target surface and layer nucleation in the synthesis of Al-Cr-O coatings deposited by reactive cathodic arc evaporation", SURFACE AND COATINGS TECHNOLOGY, ELSEVIER, AMSTERDAM, NL, vol. 205, no. 5, 25 November 2010 (2010-11-25), pages 1356-1361, XP027507490, ISSN: 0257-8972, DOI: 10.1016/J.SURFCOAT.2010.08.152 [retrieved on 2010-11-19]

## Description

The present invention relates to a coating according to claim 1 comprising at least one Al-Cr-Fe-O layer exhibiting hexagonal α-phase polycrystalline structure and comprising droplets, wherein the Al-Cr-Fe-O layer comprises Al-rich droplets and Cr-rich droplets, and the Al-rich droplets comprise mainly and mostly Al and the Cr-rich droplets comprise mainly and mostly Cr and the Al-rich droplets have a flat-shape, while the Cr-rich droplets have a spherical shape, and wherein the α-phase polycrystalline structure exhibits at least one V-shaped hexagonal crystallite which is grown on a Cr-rich droplet exhibiting spherical shape.

### State of the art and limitations

It is known from the state of the art that in addition to the thermodynamically stable hexagonal corundum-type (α, R3̅c) phase, Al₂O₃ crystallizes in several metastable polymorphs.

The corundum-type phase particularly attracts attention because of its superior oxidation resistance, thermal and mechanical stability, as well as chemical inertness. However, synthesizing single-phased α-Al₂O₃ films strongly depends on the deposition conditions of the respective technique and is still extremely challenging for deposition methods at temperatures below 600 °C.

Considerable progress towards the controlled formation of α-Al₂O₃ has been achieved by the addition of Cr in order to form a metastable solid solution (AlₓCr₁₋ₓ)₂O₃. Studies on (AlₓCr₁₋ₓ)₂O₃ coatings for different Al contents x demonstrate the potential of such alloying , which - when providing a dominant hexagonal corundum-type matrix - allows for films featuring comparable properties to α-Al₂O₃. However, a certain limitation for its efficiency is given by the maximum Al content within this solid solution as especially the favoured Al-rich compositions tend to form a metastable cubic phase when prepared by physical vapour deposition, PVD.

### Objective of the present invention

Considering the previously mentioned state of the art and having regard to the potential positive effect of Fe on oxide phases as reported in previous studies such us in WO2014111264 and US2009269600 which show that Fe facilitates the formation of protective (Al,Cr)₂O₃ corundum structures the inventors decide to analyze Al₂O₃ coatings doped with Cr and Fe in order to develop improved (Al_{1-x-y}Cr_{x-y}Fe_{y})₂O₃ coating concepts.

### Description of the present invention

The inventors study in detail alloying concepts including Cr and Fe as additions to Al₂O₃ to form quaternary corundum-type (Al_{1-x-y}Cr_{x-y}Fe_{y})₂O₃ coatings. Like Cr and Al, Fe forms an M₂O₃-type oxide with an R3c structure, its unit cell is only ∼6 and 1.6 % larger than corundum Al₂O₃ and eskolaite Cr₂O₃, respectively. Hence, Al₂O₃, Cr₂O₃, and Fe₂O₃ are potential candidates for forming a metastable solid solution when prepared by PVD, also because of the wide solubility range for each other at higher temperatures, ∼1500 °C.

Ternary (AlₓCr₁₋ₓ)₂O₃ and quaternary (Al_{1-x-y}Cr_{x-y}Fe_{y})₂O₃ thin films were deposited in an cathodic arc evaporation system of the type Oerlikon Balzers Innova. Two cathodes were either equipped with Al_{0.7}Cr_{0.3} or Fe-alloyed (1, 2, and 5 at% Fe) Al_{0.7}Cr_{0.3} targets. The term Fe-alloyed (1, 2, and 5 at.-% Fe) Al_{0.7}Cr_{0.3} in the context of the present invention is used for referring to targets composed of iron, aluminium and chromium, wherein the targets comprise 1 at.-%, 2 at.-% and 5.-at% of Fe and 99 at.-%, 98 at.-% and 95 at.-% of Al and Cr, respectively, wherein the ratio of Al/Cr in atomic percentage is ≈ 70 at.-% Al to 30 at.-% Cr. The used targets were manufactures by using powder metallurgical techniques by Plansee Composite Materials (hereafter the abbreviation PM will be used for referring to "Powder Metallurgical" prepared targets) - for details concerning chemical composition see Table 1.

The Al-Cr-Fe-O coating layers according to the present invention were produced by coating processes during which the oxygen gas flow was regulated in order to be maintained constant during the deposition of the inventive coating layers, while the pressure varied. However the coating parameters were selected in such a manner that the total gas pressure was not lower than 2 Pa.

**Table 1: Chemical composition of Al-Cr and Al-Cr-Fe targets in as-delivered condition and Al-Cr-O and Al-Cr-Fe-O coating layers in as-deposited condition examined by SEM-EDS.**

| **virgin target composition** | **O content and metallic sublattice population in deposited layers [at%]** | | | |
|---|---|---|---|---|
| | **O** | **Al** | **Cr** | **Fe** |
| Al_{0.7}Cr_{0.3} | 61.5 [58.4]* | 75.9 [76.5]* | 24.1 [23.5]* | - |
| Al_{0.695}Cr_{0.295}Fe_{0.01} | 59.1 | 72.7 | 26.3 | 1.0 |
| Al_{0.69}Cr_{0.29}Fe_{0.02} | 59.1 | 75.1 | 22.8 | 2.1 |
| Al_{0.675}Cr_{0.275}Fe_{0.05} | 59.2 | 69.7 | 25.2 | 5.1 |

| | | | | |
|---|---|---|---|---|
| *Complementary ERDA measurements are listed in squared brackets for the Fe-free (AlₓCr₁₋ₓ)₂O₃ coating layer, which was used as a calibrating standard. | | | | |

A quaternary alloying coating layer concept comprising the addition of 1-5 at% Fe to Al_{0.7}Cr_{0.3} targets for cathodic arc evaporation at 550 °C was investigated regarding the influence of Fe on promoting singe-phase α-(Al,Cr)₂O₃ film growth.

Substrate pre-treatment, including cleaning, heating, and Ar-ion etching was conducted according to J. Paulitsch, R. Rachbauer, J. Ramm, P. Polcik, P.H. Mayrhofer, Vacuum (2013), albeit using a deposition temperature of 550 °C and a base pressure of ∼7.0 10⁻³ mbar prior to the 90 minutes deposition process. The cathodic arc was operated at 180 A with an oxygen flow rate of 1000 sccm - resulting in an average process pressure of ∼2.5 10⁻² mbar - directly introduced into the chamber in front of the targets. In order to assist the film growth processes a bipolar pulsed (25 kHz) substrate bias of -60 V was applied.

Scanning electron microscopy (SEM) studies were carried out in a FEI Quanta 200 FEG-SEM operated with an acceleration voltage of 10 keV. The chemical composition and elemental mapping of the coating was thereupon obtained by energy-dispersive X-ray spectroscopy (EDS) using an EDAX Pegasus XM4 instrument (calibrated to 20 keV, which was applied for these measurements) attached to the SEM. Complementary to EDS, Elastic Recoil Detection Analyses (ERDA) were carried out using a 35 MeV Cl⁷⁺ ion beam and evaluated according to N.P. Barradas, C. Jeynes, R.P. Webb, Appl. Phys. Lett. 71 (1997) 291. The crystal structure of the coatings was investigated by) grazing incidence (GI, angle of incidence Ω = 2 deg.) X-ray diffraction (XRD) and in Bragg-Brentano arrangement (BB) from diffraction angles 2θ = 15 to 80 deg. using an Empyrean PANalytical θ-θ diffractometer with a Cu K_{α} radiation source and a Göbel mirror attachment.

Detailed information on the microstructure of our coatings was obtained by transmission electron microscopy including scanning TEM (STEM), selected area electron diffraction (SAED), and EDS. We therefore used a FEI TECNAI F20 field emission TEM with an acceleration voltage of 200 kV. Cross-sections of the coating samples were prepared by grinding and subsequent ion polishing.

Based on detailed X-ray diffraction and transmission electron microscopy studies it was determined that the α-phase fraction correlates with the incorporated Fe content and increases with increasing film thickness at the expense of the cubic phases for the coatings deposited by using the above mentioned coating conditions.

As already mentioned above, the chemical compositions of the produced (Al_{1-x-y}Cr_{x-y}Fe_{y})₂O₃ coating layers which were synthesized from cathodic arc evaporated PM Al_{0.7}Cr_{0.3} targets alloyed with 0, 1, 2, and 5 at% Fe, was obtained by SEM-EDS and ERDA, and summarised in Table 1. The coating compositions measured by ERDA were used as reference for the SEM-EDS results. Oxygen contents of -59 at% for all coatings suggest stoichiometric oxides. Fe concentrations within the films of 0.0, 1.0, 2.1, and 5.1 at% approximately reflect the respective target compositions, even though the Al/Cr ratio differs. The observed increase from the initial target condition of 7/3 (i.e. 2.3) to the oxide film ratio between 2.76 and 3.29 can partly be explained by the formation of volatile Cr-oxides and the incorporation of Al-rich droplets.

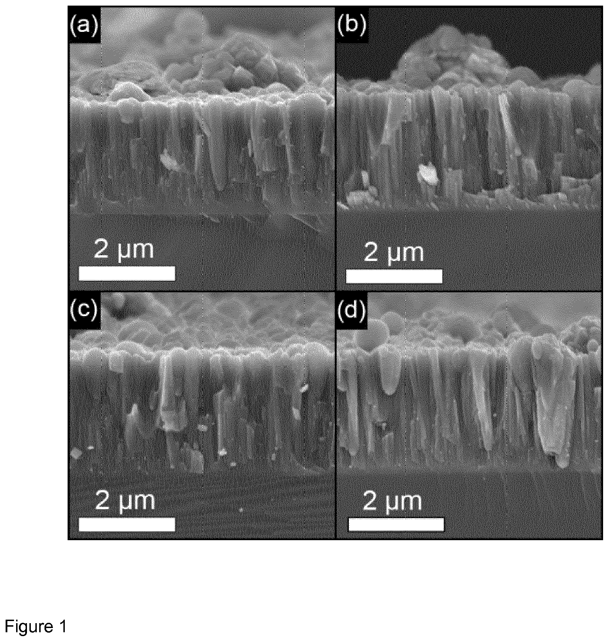

The growth morphology of the studied coatings layers is presented in SEM cross-section series, Figs. 1a-d. The rough surface appearance visible at the upper section of the images is rather typical for unfiltered cathodic arc evaporation in oxygen-rich atmospheres, depicting the presence of droplets and droplet-induced growth defects.

By comparing the fracture cross-sections the inventors recognise a subtle influence of Fe on the film growth morphology. Even though the deposition rate of all coatings is very similar (between 28 and 30 nm/min), the amorphous-like fine structured section at the substrate-to-coating interface is reduced and the columnar character appears to be more crystalline upon alloying with Fe. SEM-EDS point measurements on larger droplets - special attention was put on the differentiation between surface near droplets and growth defects induced by droplets incorporated underneath the surface - in top-view and cross-section arrangement reveal a metallic character. Predominately Fe containing particles were not found, even though the inventors observe a slight increase of Fe in spherical droplets. These observations nicely fit to the individual melting points of the elements.

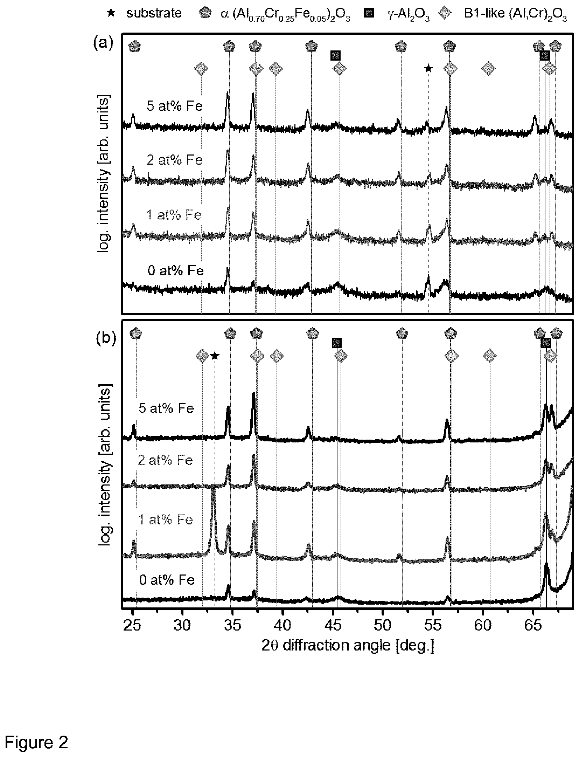

All coatings deposited exhibit an at least dual-phase crystalline structure as can be seen in the XRD patterns of Figs. 2a and b, respectively. Since neither chromium oxides nor Fe oxides could be detected, it suggest for a complete intermixing to form a solid solution (Al,Cr,Fe)₂O₃. The relatively broad peaks in the GI pattern (Fig. 2a) of the (Al_{0.76}Cr_{0.24})₂O₃ sample at 2θ ∼45.4 and 66.2 deg. can be assigned to a B1-like cubic phase. However, because of the close match of the XRD peak positions for B1-like (200) and (220) with that for γ-type Al₂O₃ (400) and (440) the identification is uncertain. A γ-type (Al,Cr)₂O₃ solid solution should result in XRD peaks at lower diffraction angles as compared with the γ-Al₂O₃ reference pattern due to the lattice expansion by the substitution of Al by Cr ions. This cannot unequivocally be observed, neither in the GI nor Bragg-Brentano configuration, see Figs. 2a and b. Consequently, the XRD data suggest that the (Al,Cr)₂O₃ and (Al,Cr,Fe)₂O₃ coatings contain cubic B1-like phases apart from the hexagonal corundum-type α-phase (as described within the subsequent paragraph). The (200) and (220) lattice plane distances obtained from the B1-like XRD peaks at 2θ = 45.4 and 66.2 deg. are 1.99±0.05 and 1.41±0.05 Å, respectively. Hence, the lattice parameter of the cubic phases within our Fe-free (Al,Cr)₂O₃ coating is 3.98±0.05 Å. The slightly increased Al content as well as strain induced effects may explain the smaller lattice parameter as compared with A. Khatibi, J. Palisaitis, C. Hoglund, A. Eriksson, P.O.Å.O.Å. Persson, J. Jensen, J. Birch, P. Eklund, L. Hultman, Thin Solid Films 519 (2011) 2426.

In addition to the XRD peaks at 45.4 and 66.2 deg., the inventors observe several reflections at 2θ ∼34.5, 37.0, 42.5, and 56.4 deg. Using a Vegard's like linear interpolation between corundum Al₂O₃ and eskolaite Cr₂O₃ allowed us to assign these XRD peaks to (101̅4), (112̅0), (112̅3), and (112̅6) lattice planes of a solid solution α-(Al,Cr)₂O₃. Comparing the GI pattern with the BB pattern (increased depth-information as compared with GI) of our Fe-free (Al_{0.76}Cr_{0.24})₂O₃ coating, Figs. 2a and b, suggests that the α-phase fraction increases with the coating thickness, whereas the substrate near film section is dominated by a cubic phase.

XRD patterns of Fe alloyed coatings, both in GI and BB arrangement, demonstrate very pronounced peaks at 2θ positions of ∼25.1, 34.5, 37.0, 42.5, 51.6, 56.4, 66.2, and 66.7 deg., which can be assigned to (011̅2), (101̅4), (112̅0), (112̅3), (022̅4), (112̅6), (213̅6), and (303̅0) lattice planes of a corundum-type solid solution (Al_{0.70}Cr_{0.25}Fe_{0.05})₂O₃, indicated by blue hexagons. A significant shift of the XRD peak positions between films exhibiting different Fe concentrations is not detectable. However, it is noteworthy that already 1 at% of Fe results in a significant increase in intensity of the hexagonal XRD peaks as compared with the (Al_{0.76}Cr_{0.24})₂O₃ coating. Furthermore, the intensity continuously increases with increasing Fe content. Especially within the 2θ-range ∼65-68 deg., the inventors observe pronounced changes due to the addition of Fe. The initially dominant cubic XRD peak at 2θ ∼66.2 deg. for (Al_{0.76}Cr_{0.24})₂O₃ continuously decreases with increasing Fe content - at the same time hexagonal (112̅6) and (213̅6) XRD peaks develop. The generally rather broad appearance of the cubic XRD peaks indicates a fine grained constitution, whereas the sharper XRD peaks of the hexagonal phase suggests for larger grain sizes.

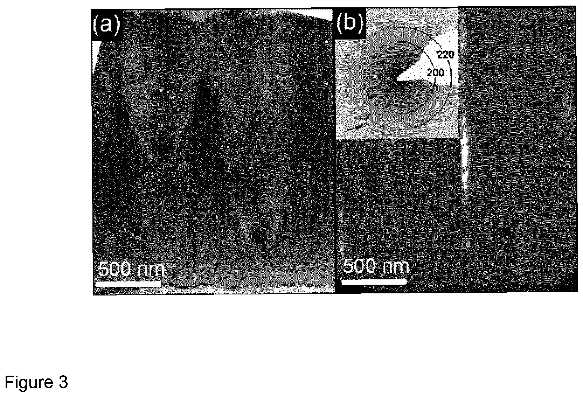

Cross-sectional TEM bright field (BF) and dark field (DF) images of Fe-free (Al_{0.76}Cr_{0.24})₂O₃ coatings in Figs. 3a and b indicate that the initial growth stage (up to around 250 nm from the substrate-coating interface) is characterised by an amorphous-like and fine-grained morphology (also compare with the respective SEM images in Fig. 1a). Selected area electron diffraction, carried out at different positions along the growth direction, shows that the hexagonal α-phase crystallises only occasionally - indicated by diffraction spots with reduced intensity. A representative SAED pattern, obtained approximately 500 nm from the substrate-coating interface is provided in Fig. 3a. The two predominant ring-patterns can be assigned to the (200) and (220) lattice planes of a cubic B1-like structure with lattice plane distances of 2.02±0.03 and 1.43±0.03 Å, hence a calculated cubic lattice parameter of 3.9±0.05 Å - a value that very well agrees with the previous XRD-based result. The TEM DF image, Fig. 3b, obtained according to the cubic (220) SAED spot marked by the black arrow in Fig. 3a, demonstrates a fine columnar morphology of the cubic matrix. The respective columns exhibit average widths of 70 nm and lengths of up to several hundred nm.

The droplets investigated by SEM-EDS were either Al-rich droplets showing a mostly flattened shape or Cr-rich droplets showing a spherical shape. The latter ones in certain cases even exhibit chemical compositions indicative for AlCr-intermetallic phases. The inventors observed that spherical particles are more easily formed for elements with higher melting points, whereas flattened particles are the result of low melting elements.

Furthermore, several spherical- and flat-shaped droplets were identified by TEM as well. In this manner the TEM-EDS measurements confirm previous results obtained by SEM-EDS.

A high defect density surrounds especially larger spherical droplets. Such defects - even when fully overgrown - extend to the coating surface and cause the pronounced surface roughness (see Figs. 3 and 1).

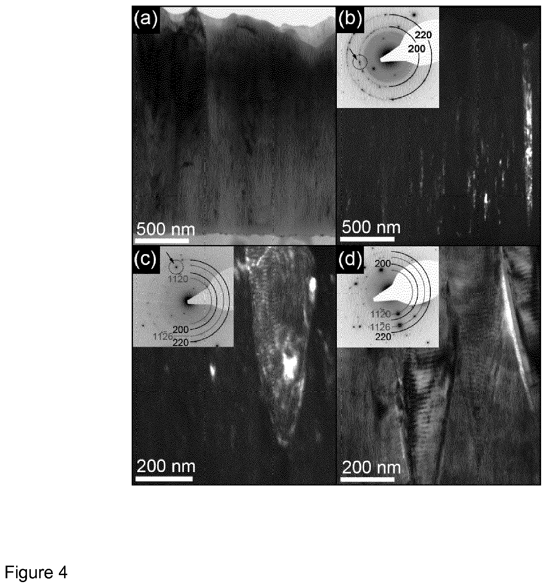

The (Al_{0.75}Cr_{0.25}Fe_{0.05})₂O₃ coating, Fig. 4a, exhibits a comparable growth morphology at the substrate-near region as the Fe-free (Al_{0.76}Cr_{0.24})₂O₃ sample. However, the extremely fine-grained substrate-near film region is not so pronounced - again this agrees to the previously discussed SEM results. Furthermore, also the SAED pattern (inset of Fig. 4b) exhibits a distinct difference to that of the Fe-free sample presented in Fig. 3b. Even though (200) and (220) diffraction rings of a cubic phase are present, additional spots with pronounced intensity at hexagonal α-phase positions can be detected as well. The corresponding DF image, Fig. 4b, is rather comparable to the respective image of the Fe-free (Al_{0.76}Cr_{0.24})₂O₃ coating but exhibits fewer areas with bright contrast. As the DF image is obtained with respect to a cubic diffraction spot, marked in the SAED inset of Fig. 4b, the fewer areas with bright contrast suggest less cubic phase fractions.

Selecting a hexagonal α-phase diffraction spot (of (1126) lattice plane) for DF imaging, Fig. 4c, reveals the presence of a large V-shaped crystallite embedded in the cubic matrix.. As can be seen from Fig.4c, this V-shaped hexagonal crystallite originates from a spherical droplet with a diameter smaller than 50 nm. In Fig. 4d we show another representative sample position featuring multiple α-phase crystallites next to each other. Especially pronounced α-phase diffraction spots - indicative for large and well-defined crystallites - can be detected by SAED, whereas the intensity of the cubic pattern is significantly reduced.

Further HR TEM investigations (not shown here) were performed to elucidate the microstructure of the α-phased crystallites, and revealed well-defined lattice fringes with an average lattice plane distance of ∼2.5±0.2 Å, which is in excellent agreement with literature values of 2.511 and 2.665 Å for the (1014) lattice planes of corundum Al₂O₃ and eskolaite Cr₂O₃, respectively. Nucleation of cubic phases on top of the hexagonal phase could not be observed, unless triggered by the incorporation of macroparticles.

The inventors found that surprisingly already small additions of Fe to the respective Al_{0.7}Cr_{0.3} PM target facilitate the growth of hexagonal (a-phase) solid solution (Al,Cr,Fe)₂O₃ phases if coating layers are deposited according to the above mentioned conditions, as it was confirmed by the detailed SEM, XRD, and TEM invenstigations. The fraction of distinct V-shaped hexagonal crystallites increases with increasing film thickness as well as increasing Fe content at the expanse of the cubic phases. Consequently, the development of single-phases α-type Al-based oxide coatings - by cathodic arc evaporation at relatively low temperatures of around 550 °C - is accessible through the advanced alloying and architecture concept of Al-Cr-Fe-O coating layers according to the present invention.

The inventors think that the conduction of oxygen flow regulated coating processes during which the coating parameters were selected in order to obtain total pressures not lower than 2 Pa, as described above, promoted the generation of droplets in such a way that the formation of the inventive coating layers was made possible.

### Figure captions:

- Figure 1:
   SEM cross-section studies of
   (a) (Al_{0.76}Cr_{0.24})₂O₃,
   (b) (Al_{0.73}Cr_{0.26}Fe_{0.01})₂O₃,
   (c) (Al_{0.75}Cr_{0.23}Fe_{0.02})₂O₃, and
   (d) (Al_{0.70}Cr_{0.25}Fe_{0.05})₂O₃
   coatings.
- Figure 2:
   X-ray diffraction patterns of (Al_{0.76}Cr_{0.24})₂O₃, (Al_{0.73}Cr_{0.26}Fe_{0.01})₂O₃, (Al_{0.75}Cr_{0.23}Fe_{0.02})₂O₃, and (Al_{0.70}Cr_{0.25}Fe_{0.05})₂O₃ coatings on Si substrate evaluated in (a) grazing incidence (angle of incidence Ω = 2 °) and (b) Bragg-Brentano arrangement. The standard XRD peak positions for a hexagonal (Al,Cr,Fe)₂O₃ solid solution are approximated according to the chemical composition of the 5 at% Fe coating using the ICDD #00-038-1479, #00-046-1212, and IDD #00-033-0664 patterns for hexagonal Al₂O₃, Cr₂O₃, and Fe₂O₃ respectively.
- Figure 3: (a) Cross-sectional TEM BF image of a (Al_{0.76}Cr_{0.24})₂O₃ sample, (b) Corresponding DF image using a cubic 220 reflection, indicated by the black arrow in the SAED inset, showing pronounced cubic (200) and (220) ring patterns.
- Figure 4: (a) Cross-sectional TEM BF image of (Al_{0.70}Cr_{0.25}Fe_{0.05})₂O₃, (b) and (c) represent DF images with respect to cubic and hexagonal crystallites including the corresponding SAED patterns, respectively, (d) BF image of several adjacent V-shaped hexagonal crystallites. The corresponding SAED inset demonstrates their distinct crystalline character.

The present invention relates concretely to:
A coating according to claim 1 comprising at least one Al-Cr-Fe-O layer exhibiting hexagonal α-phase polycrystalline structure and comprising droplets, wherein
- the Al-Cr-Fe-O layer comprising Al-rich droplets and Cr-rich droplets, wherein the Al-rich droplets comprise mainly and mostly Al and the Cr-rich droplets comprise mainly and mostly Cr, and wherein the Al-rich droplets exhibit a flat-shape, while the Cr-rich droplets exhibit a spherical shape, and
- the hexagonal α-phase polycrystalline structure having at least one V-shaped hexagonal crystallite which is grown on a Cr-rich droplet exhibiting spherical shape.

According to a preferred embodiment of a coating according to the present invention one or more Cr-rich droplets exhibiting spherical shape comprise at least one Al-Cr intermetallic phase.

According to a further preferred embodiment of a coating according to the present invention one or more Cr-rich droplets exhibiting spherical shape have diameter smaller than 200 nm, preferably smaller than 100 nm, more preferably smaller than 90 nm.

According to one more preferred embodiment of a coating according to the present invention the Al-Cr-Fe-O layer comprises an oxide phase defined by the chemical formula (Al,Cr,Fe)₂O₃, wherein this phase is the most dominant oxide phase in the Al-Cr-Fe-O layer.

According to a preferred embodiment of a coating according to the present invention the Al-Cr-Fe-O layer comprises aluminium and chromium in a ratio Al/Cr of ≈ 70 at.-% Al to 30 at.-% Cr and iron in a concentration in atomic percentage not higher than 5 at.-% if only the metallic components Al, Cr and Fe in the Al-Cr-Fe-O layer are considered.

## Claims

1. Coating comprising at least one Al-Cr-Fe-O layer exhibiting hexagonal α-phase polycrystalline structure and comprising droplets, whereby an Fe concentration within the coating reflects approximately a target composition of 1 to 5 at% Fe in addition to AlCr **characterized by**
- the Al-Cr-Fe-O layer comprising Al-rich droplets and Cr-rich droplets, wherein the Al-rich droplets comprise Al and the Cr-rich droplets comprise Cr, and wherein the Al-rich droplets exhibit a flat-shape, while the Cr-rich droplets exhibit a spherical shape, and
- the hexagonal α-phase polycrystalline structure having at least one V-shaped hexagonal crystallite which is grown on a Cr-rich droplet exhibiting spherical shape.

2. Coating according to claim 1, **characterized by** one or more Cr-rich droplets exhibiting spherical shape comprising at least one Al-Cr intermetallic phase.

3. Coating according to claim 1 or 2, **characterized by** one or more Cr-rich droplets exhibiting spherical shape having diameter smaller than 200 nm.

4. Coating according to claim 3, **characterized by** one or more Cr-rich droplets exhibiting spherical shape having diameter smaller than 100 nm.

5. Coating according to claim 4, **characterized by** one or more Cr-rich droplets exhibiting spherical shape having diameter smaller than 90 nm.

6. Coating according to any of the previous claims 1 to 5, **characterized by** the Al-Cr-Fe-O layer comprising an oxide phase defined by the chemical formula (Al,Cr,Fe)₂O₃, wherein this phase is the most dominant oxide phase in the Al-Cr-Fe-O layer.

7. Coating according to any of the previous claims 1 to 6, **characterized by** the Al-Cr-Fe-O layer comprising aluminium and chromium in a ratio Al/Cr of 70 at.-% Al to 30 at.-% Cr and iron in a concentration in atomic percentage not higher than 5 at.-% if only the metallic components Al, Cr and Fe in the Al-Cr-Fe-O layer are considered.

## Patentansprüche

1. Beschichtung, umfassend wenigstens eine Al-Cr-Fe-O-Schicht, die eine hexagonale α-Phasen in polykristalliner Struktur aufweist und Tröpfchen umfasst, wobei eine Fe-Konzentration in der Beschichtung annähernd einer Target-Zusammensetzung von 1 bis 5 At.-% Fe zusätzlich zu AlCr entspricht, **dadurch gekennzeichnet, dass**
- die Al-Cr-Fe-O-Schicht Al-reiche Tröpfchen und Cr-reiche Tröpfchen umfasst, wobei die Al-reichen Tröpfchen Al umfassen und die Cr-reichen Tröpfchen Cr umfassen, und wobei die Al-reichen Tröpfchen eine flache Form aufweisen, während die Cr-reichen Tröpfchen eine kugelförmige Form aufweisen, und
- die hexagonale polykristalline α-Phasen-Struktur wenigstens einen V-förmigen hexagonalen Kristallit aufweist, der auf einem Cr-reichen Tröpfchen aufgewachsen ist, das eine kugelförmige Form aufweist.

2. Beschichtung nach Anspruch 1, **gekennzeichnet durch** ein oder mehrere Cr-reiche Tröpfchen, die eine kugelförmige Form aufweisen und wenigstens eine intermetallische Al-Cr-Phase umfassen.

3. Beschichtung nach Anspruch 1 oder 2, **gekennzeichnet durch** ein oder mehrere Cr-reiche Tröpfchen, die eine kugelförmige Form mit einem Durchmesser von weniger als 200 nm aufweisen.

4. Beschichtung nach Anspruch 3, **gekennzeichnet durch** ein oder mehrere Cr-reiche Tröpfchen, die eine kugelförmige Form mit einem Durchmesser von weniger als 100 nm aufweisen.

5. Beschichtung nach Anspruch 4, **gekennzeichnet durch** ein oder mehrere Cr-reiche Tröpfchen, die eine kugelförmige Form mit einem Durchmesser von weniger als 90 nm aufweisen.

6. Beschichtung nach einem der vorhergehenden Ansprüche 1 bis 5, **dadurch gekennzeichnet, dass** die Al-Cr-Fe-O-Schicht eine Oxidphase umfasst, die durch die chemische Formel (Al,Cr,Fe)₂O₃ definiert ist, wobei diese Phase die dominanteste Oxidphase in der Al-Cr-Fe-O-Schicht ist.

7. Beschichtung nach einem der vorhergehenden Ansprüche 1 bis 6, **dadurch gekennzeichnet, dass** die Al-Cr-Fe-O-Schicht Aluminium und Chrom in einem Verhältnis Al/Cr von 70 At.-% Al zu 30 At.-% Cr und Eisen in einer Konzentration in Atomprozent von nicht mehr als 5 At.-% umfasst, wenn nur die metallischen Komponenten Al, Cr und Fe in der Al-Cr-Fe-O-Schicht berücksichtigt werden.

## Revendications

1. Revêtement comprenant au moins une couche Al-Cr-Fe-O présentant une structure polycristalline à phase a hexagonale et comprenant des gouttelettes, dans lequel une concentration de Fe dans le revêtement reflète approximativement une composition cible de 1 à 15 % atomique de Fe en plus de AlCr, **caractérisé par**
- la couche Al-Cr-Fe-O comprenant des gouttelettes riches en Al et des gouttelettes riches en Cr, les gouttelettes riches en Al comprenant du Al et les gouttelettes riches en Cr comprenant du Cr, et les gouttelettes riches en Al présentant une forme plate, tandis que les gouttelettes riches en Cr présentent une forme sphérique, et
- la structure polycristalline à phase a hexagonale ayant au moins une cristallite hexagonale en forme de V qui sont mis à cro tre sur une gouttelette riche en Cr présentant une forme sphérique.

2. Revêtement selon la revendication 1, **caractérisé par** une ou plusieurs gouttelettes riches en Cr présentant une forme sphérique comprenant au moins une phase intermétallique Al-Cr.

3. Revêtement selon la revendication 1 ou 2, **caractérisé par** une ou plusieurs gouttelettes riches en Cr présentant une forme sphérique avec un diamètre inférieur à 200 nm.

4. Revêtement selon la revendication 3, **caractérisé par** une ou plusieurs gouttelettes riches en Cr présentant une forme sphérique avec un diamètre inférieur à 100 nm.

5. Revêtement selon la revendication 4, **caractérisé par** une ou plusieurs gouttelettes riches en Cr présentant une forme sphérique avec un diamètre inférieur à 90 nm.

6. Revêtement selon l'une des revendications 1 à 5, **caractérisé par** la couche Al-Cr-Fe-O comprenant une phase oxyde définie par la formule chimique (Al,Cr,Fe)₂O₃, cette phase étant la phase oxyde la plus dominante dans la couche Al-Cr-Fe-O.

7. Revêtement selon l'une des revendications 1 à 6, **caractérisé par** la couche Al-Cr-Fe-O comprenant de l'aluminium et du chrome dans un rapport Al/Cr de 70 % atomique, Al à 30 % atomique, Cr et le fer dans une concentration en pourcentage atomique n'excédant pas 5 % atomique si seuls les composants métalliques Al, Cr et Fe sont considérés dans la couche Al-Cr-Fe-O.
